Europäisches Patentamt

European Patent Office

Office européen des brevets

(11) Numéro de publication: **0 041 041**
**A1**

## (12) DEMANDE DE BREVET EUROPEEN

(21) Numéro de dépôt: **81810173.5**

(51) Int. Cl.³: **H 05 K 13/04,** H 05 K 13/00

(22) Date de dépôt: **06.05.81**

(30) Priorité: **19.05.80 CH 3878/80**

(43) Date de publication de la demande: **02.12.81**
**Bulletin 81/48**

(84) Etats contractants désignés: **BE CH DE FR GB LI LU NL
SE**

(71) Demandeur: **Les Fabriques d'Assortiments Réunies,
57, rue Girardet, CH-2400 Le Locle (CH)**

(72) Inventeur: **Lebet, Jean-Philippe, route de Coffrane 22,
CH-2206 Les Geneveys sur Coffrane (CH)**
Inventeur: **Peterle, Leonardo, CH-2115 Buttes (CH)**

(74) Mandataire: **Schneider, Jürg et al, c/o ASUAG Faubourg
du Lac 6, CH-2501 Bienne (CH)**

(54) Procédé et dispositif de report d'un composant électronique sur un substrat.

(57) Le dispositif de report comporte: un poste de découpage (1) pour réaliser la séparation du composant (22) monté préalablement dans une ouverture d'un support souple dans laquelle se projettent radialement des éléments conducteurs dont les extrémités intérieures sont soudées aux zones de raccordement du composant; un poste d'alignement (2) pour aligner le composant et le substrat, des moyens de transfert (6, 7, 8) pour prélever un composant au poste de découpage et l'amener à celui d'alignement, et un outil de soudage (11) pour réaliser la connexion électrique du composant positionné sur son substrat (4).

EP 0 041 041 A1

209.116-BE

Procédé et dispositif de report d'un composant électronique
sur un substrat.

La présente invention concerne un procédé pour reporter un composant
électronique, du type d'un circuit intégré, sur un substrat prévu
pour le recevoir, ainsi qu'un dispositif pour la mise en oeuvre de
ce procédé.

L'invention se rapporte plus particulièrement à la technique de
montage de composants connue sous la dénomination TAB ou "Tape
Automated Bonding" selon laquelle chaque composant individuel est
tout d'abord monté dans une ouverture d'un support souple dans
laquelle se projettent radialement des éléments conducteurs, les
extrémités intérieures de ces éléments conducteurs étant soudées
aux zones de raccordement correspondantes formées sur le composant.
Le support souple peut se présenter sous forme d'un film comportant
une succession d'ouvertures, ou d'un support individuel solidaire
d'un cadre à la manière de vues diapositives, mais dans l'un ou
l'autre cas, il peut être utilisé pour réaliser une indexation
précise du composant qu'il porte relativement à un repère déterminé.

C'est pourquoi, lors des opérations classiques de report du composant ainsi monté sur le support souple, on présume que sa position
est exactement définie relativement à l'outil de soudage, et on ne réalise donc plus qu'un positionnement du substrat relativement à un repère fixe associé à l'installation. On s'aperçoit toutefois que cette technique n'est plus satisfaisante lorsque les composants sont très fortement intégrés et qu'ils présentent un nombre croissant de pattes de connexion. Dans ce cas, les tolérances dimensionnelles requises pour les supports souples sont telles que leur coût de fabrication devient prohibitif et en outre, la moindre détérioration du support ou des conducteurs formés sur celui-ci par exemple lors de l'opération de découpage des pattes de connexion, conduisent à l'échec de l'opération de soudage.

C'est pourquoi, l'un des objets de l'invention est de réaliser un procédé de report qui, de façon surprenante, permette de s'affranchir de tolérances très serrées dans les dimensions des supports souples, en prévoyant de procéder aux opérations de:

- séparer le composant électronique de son support par un découpage simultané des éléments conducteurs, les portions de ces éléments soudées aux zones de raccordement formant alors les pattes de connexion du composant

- amener le composant équipé de ses pattes de connexion au-dessus du substrat

- positionner correctement le substrat relativement au composant

- déposer le composant sur le substrat, dans la position précédemment déterminée

- si nécessaire positionner l'ensemble composant-substrat relativement à un outil de soudage; et

- appliquer l'outil de soudage à l'ensemble composant-substrat et réaliser leur raccordement électrique.

Ce procédé peut être mis en oeuvre par divers dispositifs, et l'invention se propose également de prévoir une installation particulièrement adaptée à cette fin.

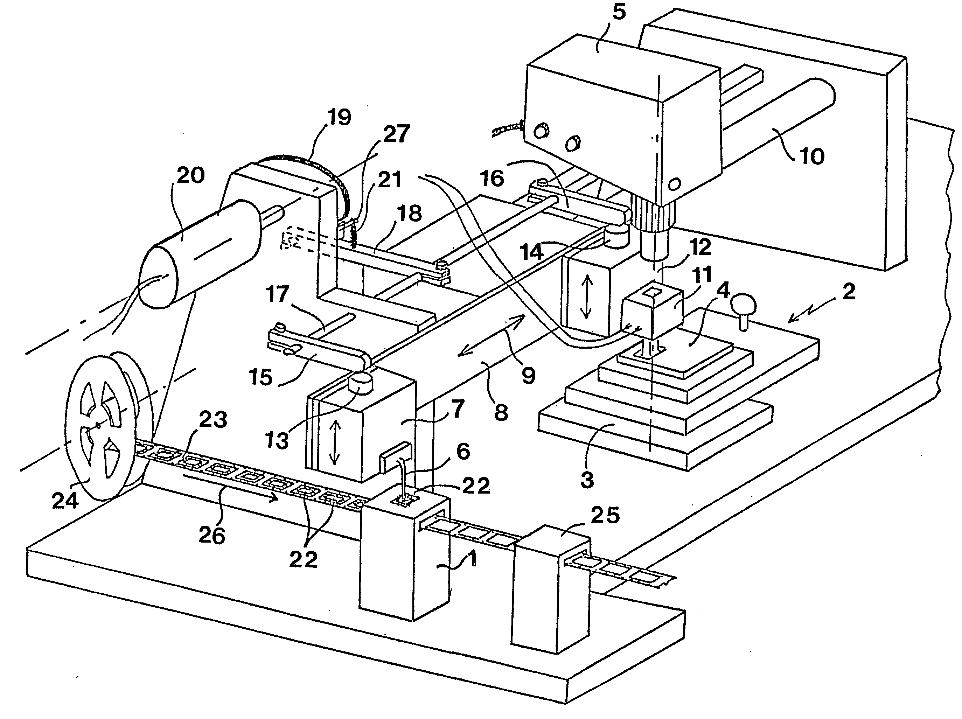

L'invention sera bien comprise à la lecture de la description suivante, faite en référence à la figure jointe, qui représente de façon schématique une installation de report pour la mise en oeuvre du procédé.

L'installation comporte notamment un poste de découpage 1 comprenant un outil de découpe pour réaliser la séparation successive des composants 22 et du support souple 23 sur lequel ils sont montés. Le support souple 23 est ici un film se déroulant d'une bobine débitrice 24 et défilant dans la direction de la flèche 26 au moyen de dispositifs d'entraînement intégrés au bloc d'avancement 25.

Elle comporte en outre un poste d'alignement généralement référencé 2 comprenant une table de positionnement 3 pour recevoir le substrat 4 et le déplacer en rotation et selon deux axes horizontaux orthogonaux. Une caméra de télévision 5 ou tout moyen optique équivalent est prévue pour surveiller les opérations d'alignement.

De plus, l'installation comporte des moyens de transfert comprenant une pipette d'aspiration 6 pour prélever chaque composant au poste de découpage 1 et l'amener au-dessus du substrat 4. La pipette 6 est assujettie à un bloc porte-pipette 7 monté coulissant verticalement sur un support 8 déplaçable dans la direction de la flèche 9, parallèlement à la direction des postes de découpage 1 et d'alignement 2, et coulissant sur des guides 10.

Sur le même support 8, à une distance égale à celle des postes d'alignement 2 et de découpage 1, c'est-à-dire à celle des axes de la caméra 5 et de l'outil de découpage, est monté un outil de soudage 11 assujetti à un bloc porte-outil 12 coulissant également verticalement sur le support 8.

A la partie supérieure des blocs 7 et 12 sont prévues des butées 13, 14 sur lesquelles viennent s'appuyer des leviers 15, 16 montés en position réglable sur une tige commune 17, sollicitée en rotation par l'une des extrémités d'une barre de commande 18.

Une came 19 entraînée par le moteur 20 s'appuie sur l'autre extrémité de la barre 18 pour faire se relever simultanément les blocs 7 et 12, tandis qu'un ressort 21 la sollicite dans le sens opposé pour faire s'abaisser ces mêmes blocs 7 et 12. Ainsi, la force d'appui des leviers sur les butées correspondantes des blocs n'est déterminée, lorsque ceux-ci sont actionnés vers le bas, que par la tension de réglage du ressort 21, ou de tout autre élément de rappel, par exemple une tige actionnée par des moyens pneumatiques ou hydrauliques. L'effort exercé par l'élément de rappel peut aisément être réglé par exemple en déplaçant l'organe 27 auquel est accroché le ressort 21, au moyen d'un moteur, ou dans le cas de la tige, en ajustant la pression du fluide alimentant les moyens pneumatiques ou hydrauliques.

Le fonctionnement de l'installation de la figure se comprend aisément. Tout d'abord, chaque composant électronique 22 est séparé de son support souple 23 au niveau du poste de découpage 1. Le bloc porte-pipette 7 est alors abaissé, pour que la pipette 6 puisse saisir par aspiration le composant 22 à la partie supérieure du poste 1. A ce moment, l'aspiration étant maintenur, le bloc 7 est à nouveau relevé, puis l'ensemble du support 8 est déplacé latéralement vers la droite pour amener le composant dans l'axe de la caméra 5. Après avoir abaissé le composant 22 à proximité immédiate du substrat 4, ce dernier est ensuite positionné correctement par rapport au composant 22 par déplacement de la table 3, et le composant est déposé lors d'un nouveau déplacement vertical du bloc 7.

Après que ce dernier ait été relevé, le support 8 est ramené dans sa position représentée, dans laquelle l'outil 11 vient se placer au-dessus de l'ensemble substrat-composant, dans l'axe de la caméra 5. Si nécessaire, l'ensemble substrat-composant peut être positionné relativement à l'outil, avant ou après la mise en place de celui-ci. Le bloc porte-outil est ensuite actionné vers le bas, et l'outil vient réaliser la connexion électrique du composant et du substrat, la pression de l'outil pouvant être réglée en modifiant la tension du ressort comme décrit ci-dessus. Simultanément, la pipette 6 vient prélever un nouveau composant à la partie supérieure du poste de découpage 1 et le cycle décrit ci-dessus peut alors reprendre.

Bien que la présente invention ait été décrite en liaison avec un mode de réalisation particulier, elle ne s'y trouve nullement limitée mais elle est au contraire susceptible de nombreuses modifications et variantes qui apparaîtront à l'homme de l'art.

0041041
- 7 -

## Revendications

1.  Procédé de report d'un composant électronique sur un substrat, le composant électronique étant monté dans une ouverture d'un support souple dans laquelle se projettent radialement des éléments conducteurs dont les extrémités intérieures sont soudées aux zones de raccordement du composant électronique, caractérisé en ce qu'il comporte les opérations suivantes:

    - séparer le composant électronique de son support par un découpage simultané des éléments conducteurs, les portions de ces éléments soudées aux zones de raccordement formant alors les pattes de connexion du composant

    - amener le composant équipé de ses pattes de connexion au-dessus et à proximité immédiate du substrat

    - positionner correctement le substrat relativement au composant

    - déposer le composant sur le substrat, dans la position précédemment déterminée

    - si nécessaire positionner l'ensemble composant-substrat relativement à un outil de soudage; et

- appliquer l'outil de soudage à l'ensemble composant-substrat et réaliser leur raccordement électrique.

2. Dispositif de report pour la mise en oeuvre du procédé de la revendication 1, caractérisé en ce qu'il comporte notamment:

- un poste de découpage pour réaliser la séparation du composant électronique de son support

- un poste d'alignement pour positionner le composant et le substrat prévu pour le recevoir

- des moyens de transfert pour prélever le composant après découpage, l'amener au poste d'alignement, puis le déposer sur le substrat; et

- un outil de soudage pour réaliser le raccordement électrique du composant et du substrat.

3. Dispositif de report selon la revendication 2, caractérisé en ce que les moyens de transfert et l'outil de soudage sont solidaires d'un même support déplaçable parallèlement à la direction des postes de découpage et d'alignement, l'écartement des moyens de transfert et de l'outil de soudage correspondant en outre à la distance de ces postes.

4. Dispositif selon la revendication 2 ou 3, caractérisé en ce que les moyens de transfert et l'outil de soudage sont montés sur le support commun de façon à pouvoir se déplacer verticalement sous l'action de leviers

5. Dispositif selon la revendication 4, caractérisé en ce que les leviers d'actionnement des moyens de transfert et de l'outil de soudage sont solidaires d'une tige commune sollicitée en rotation par l'intermédiaire d'une barre de commande dans un sens par une came entraînée par un rotor et dans l'autre par un élément de rappel.

6. Dispositif selon la revendication 5, caractérisé en ce que les leviers d'actionnement sont montés en position réglable sur la tige.

7. Dispositif selon la revendication 5 ou 6, caractérisé en ce que l'élément de rappel sollicite les moyens de transfert et l'outil de soudage vers le bas.

8. Dispositif selon la revendication 7, caractérisé en ce que l'effort exercé par l'élément de rappel est réglable.

9. Dispositif selon la revendication 8, caractérisé en ce que l'élément de rappel est un ressort dont l'une des extrémités est solidaire de la barre de commande, l'autre extrémité étant solidaire d'un organe dont la position est réglable au moyen d'un moteur.

10. Dispositif selon la revendication 8, caractérisé en ce que l'élément de rappel est une tige actionnée par des moyens pneumatiques.

0041041

| Catégorie | Citation du document avec indication, en cas de besoin, des parties pertinentes | Revendication concernée | CLASSEMENT DE LA DEMANDE (Int. Cl.³) |
|---|---|---|---|
| | **DOCUMENTS CONSIDERES COMME PERTINENTS** | | |
| X | FR - A - 2 379 909 (CII-HONEYWELL BULL)<br><br>* page 6, ligne 1 - page 3, ligne 30; revendications *<br><br>-- | 1,2,4, 5,9 | H 05 K 13/04<br>13/00 |
| | US - A - 4 044 460 (H.I. SCHACHTER)<br><br>* colonne 6, ligne 41 - colonne 17, ligne 13; revendications *<br><br>-- | 1,2 | |
| | DE - A - 2 655 773 (W.S. FORTUNE)<br><br>* revendications; figures *<br><br>-- | 1,5,7, 9 | **DOMAINES TECHNIQUES RECHERCHES (Int. Cl.³)**<br><br>H 05 K 13/04<br>13/00<br>13/02 |
| | US - A - 4 030 180 (M.V. PIERSON)<br><br>* colonne 2, ligne 58 - colonne 7, ligne 14; revendications *<br><br>-- | 1,2 | |
| | FR - A - 2 307 442 (MATSUSHITA)<br><br>* revendications *<br><br>------ | 1,2 | |

**CATEGORIE DES DOCUMENTS CITES**

X: particulièrement pertinent
A: arrière-plan technologique
O: divulgation non-écrite
P: document intercalaire
T: théorie ou principe à la base de l'invention
E: demande faisant interférence
D: document cité dans la demande
L: document cité pour d'autres raisons

&: membre de la même famille, document correspondant

Le présent rapport de recherche a été établi pour toutes les revendications

| Lieu de la recherche | Date d'achèvement de la recherche | Examinateur |
|---|---|---|
| La Haye | 12-08-1981 | GORUN |